(19) Europäisches Patentamt
European Patent Office
Office européen des brevets

(11) **EP 3 483 310 B1**

(12) **EUROPEAN PATENT SPECIFICATION**

(45) Date of publication and mention
of the grant of the patent:
**10.06.2020 Bulletin 2020/24**

(51) Int Cl.:
**C30B 13/12** *(2006.01)*       **C30B 13/20** *(2006.01)*
**C30B 29/06** *(2006.01)*

(21) Application number: **18205387.6**

(22) Date of filing: **09.11.2018**

(54) **MONOCRYSTALLINE SILICON PRODUCTION APPARATUS AND MONOCRYSTALLINE SILICON PRODUCTION METHOD**

VORRICHTUNG ZUR HERSTELLUNG VON MONOKRISTALLINEM SILICIUM UND VERFAHREN ZUR HERSTELLUNG VON MONOKRISTALLINEM SILICIUM

APPAREIL DE PRODUCTION DE SILICIUM MONOCRISTALLIN ET PROCÉDÉ DE PRODUCTION DE SILICIUM MONOCRISTALLIN

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.11.2017 JP 2017218314**

(43) Date of publication of application:
**15.05.2019 Bulletin 2019/20**

(73) Proprietor: **SUMCO CORPORATION**
**Minato-ku**
**Tokyo 105-8634 (JP)**

(72) Inventor: **SAGAWA, Hiroyuki**
**Nagasaki, 856-8555 (JP)**

(74) Representative: **Hoffmann Eitle**
**Patent- und Rechtsanwälte PartmbB**
**Arabellastraße 30**
**81925 München (DE)**

(56) References cited:
**JP-A- 2017 141 130     US-A1- 2003 192 470**

**Description**

**TECHNICAL FIELD**

The present invention relates to a monocrystalline silicon production apparatus and a monocrystalline silicon production method.

**BACKGROUND ART**

A floating zone process has been known as a monocrystalline silicon production method.

According to the floating zone process, a material rod of a silicon polycrystal is partly heated with an induction heating coil to form a melt zone, and the material rod and a monocrystalline silicon, which are respectively located above and below the melt zone, are moved downward while the melt zone is supported by surface tension, thus gradually growing the monocrystalline silicon.

For example, JP 2017 141130 A (Patent Literature 1) describes a semiconductor single crystal manufacturing method by the floating-zone method while blowing a dopant gas from a gas dope nozzle to the floating zone. US 2003/192470 A1 (Patent Literature 2) describes a process for producing a doped semiconductor wafer by float zone pulling of a single crystal and dividing up the single crystal, in which process, during the float zone pulling, a molten material which is produced using an induction coil is doped with a dopant.

A typical induction heating coil for a monocrystalline silicon production apparatus based on the floating zone method is shaped such that a bottom surface of the induction heating coil has an outer edge that is located lower than an inner edge thereof (see, for instance, Patent Literature 3: JP 2013-177254 A).

Unfortunately, a monocrystalline silicon grown with use of the apparatus of Patent Literature 3 is likely to have an uneven resistivity distribution in a cross section perpendicular to a center axis of the monocrystalline silicon, since a dopant is not sufficiently incorporated into an outer periphery of the monocrystalline silicon and a resistivity of the outer periphery becomes higher than a resistivity at a center thereof.

**SUMMARY OF THE INVENTION**

An object of the invention is to provide a monocrystalline silicon production apparatus and a monocrystalline silicon production method that are configured to improve the evenness of the resistivity distribution of a cross section perpendicular to a center axis of a monocrystalline silicon.

After dedicated studies, the inventor has found the following.

As shown in Fig. 6, during the growth of a monocrystalline silicon SM, a minimum distance D1 between an outer periphery M1, which is shown by a chain double-dashed line, of a melt zone M and a bottom surface 412 of an induction heating coil 41 is shorter than a minimum distance between the other portion and the bottom surface 412. Thus, the outer periphery M1 is heated to a higher temperature than a portion at the inside thereof and, consequently, has a larger temperature gradient in a vertical direction than the portion at the inside thereof. Such a temperature gradient causes a strong flow C10. In addition to the flow C10, other flows C are also caused depending on a temperature distribution of the melt zone M.

The strong flow C10 caused in the outer periphery M1 reduces a thickness of a diffusion boundary layer for a doping gas in the outer periphery M1 and, consequently, reduces a volume of the doping gas incorporated into the outer periphery M1. This is speculated to increase a resistivity of the outer periphery M1, thus lowering the evenness of the resistivity distribution.

The inventor has made the invention in view of the above findings.

According to an aspect of the invention, a monocrystalline silicon production apparatus configured to implement a floating zone process includes: an induction heating coil configured to heat a silicon material to form a melt zone and solidify the melt zone to grow a monocrystalline silicon, the induction heating coil having a substantial ring shape, a bottom surface of the induction heating coil having an outer edge located lower than an inner edge; a doping gas blower configured to blow a doping gas to the melt zone; and a cooling gas blower configured to blow a cooling gas to an outer periphery of the melt zone located below a position receiving the doping gas.

According to another aspect of the invention, a monocrystalline silicon production method based on a floating zone process is configured to be implemented using an induction heating coil configured to heat a silicon material to form a melt zone and solidify the melt zone to grow a monocrystalline silicon, the induction heating coil having a substantial ring shape, a bottom surface of the induction heating coil having an outer edge located lower than an inner edge. The method includes blowing a doping gas to the melt zone while blowing a cooling gas to an outer periphery of the melt zone located below a position receiving the doping gas to cool the outer periphery to grow the monocrystalline silicon.

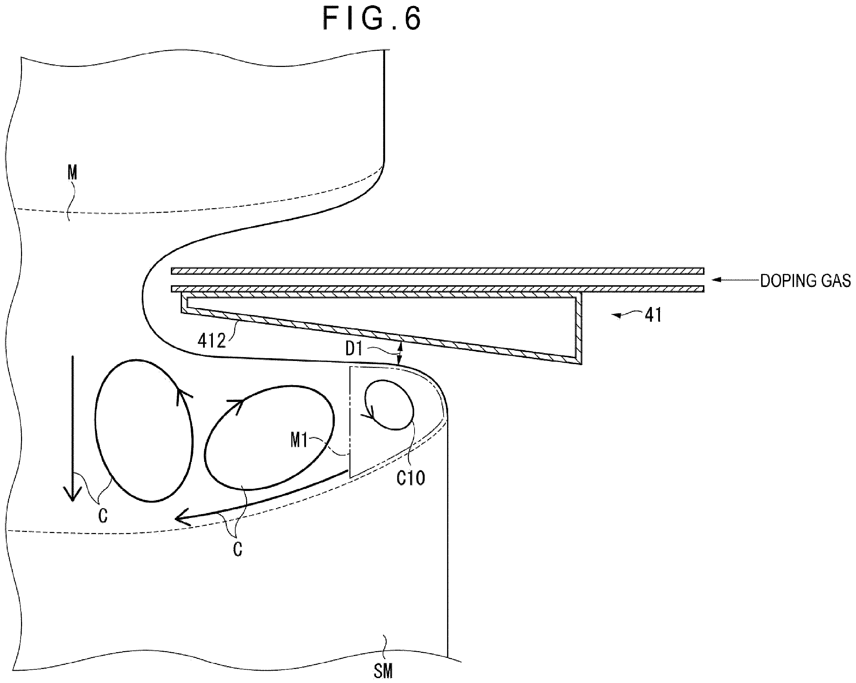

In the above aspects, the outer periphery is cooled by blowing the cooling gas to the outer periphery, which is located below the position receiving the doping gas in the melt zone, reducing the temperature gradient of the outer periphery in the vertical direction as compared with the arrangement shown in Fig. 6. A flow in the outer periphery thus becomes weak (the outer periphery settles), thickening a diffusion boundary layer for the doping gas and, consequently, increasing a volume of the doping gas incorporated into the outer periphery. As a result, the resistivity of the outer periphery is lowered to improve the evenness of the resistivity distribution.

In the monocrystalline silicon production apparatus of the above aspect, it is preferable that the induction heating coil is provided with a slit extending from an inner edge to an outer edge of the substantial ring shape, and the cooling gas blower is located such that the cooling gas is blown to the outer periphery of the melt zone, the outer periphery being, assuming that an imaginary line connecting a center of the induction heating coil and an outer end of the slit is set as a reference, located at a position at an angle ranging from 135 degrees to 225 degrees relative to the imaginary line in a top view.

In the monocrystalline silicon production method of the above aspect, it is preferable that the induction heating coil is provided with a slit extending from an inner edge to an outer edge of the substantial ring shape, and the cooling gas is blown to a portion of the outer periphery of the melt zone, the portion of the outer periphery being, assuming that an imaginary line connecting a center of the induction heating coil and an outer end of the slit is set as a reference, located at a position at an angle ranging from 135 degrees to 225 degrees relative to the imaginary line in a top view.

The melt zone, which is heated by the induction heating coil, has a highest temperature at a portion under the slit. Thus, blowing the cooling gas to a portion of the outer periphery under the slit is unlikely to improve the evenness of the resistivity distribution, since the outer periphery cannot be cooled.

In contrast, in the above aspects, the cooling gas is blown to the portion of the outer periphery of the melt zone at an angle ranging from 135 degrees to 225 degrees relative to the imaginary line in the top view (i.e., a portion opposite the slit with respect to the center of the induction heating coil and having a lower temperature than the portion under the slit), thereby cooling the outer periphery and, consequently, improving the evenness of the resistivity distribution.

In the monocrystalline silicon production apparatus of the above aspect, it is preferable that the cooling gas blower is located such that the cooling gas is blown to the portion of the outer periphery of the melt zone, the portion of the outer periphery being located at the position at the angle ranging from 175 degrees to 185 degrees relative to the imaginary line.

In the monocrystalline silicon production method of the above aspect, it is preferable that the cooling gas is blown to the portion of the outer periphery of the melt zone, the portion of the outer periphery being located at the position at the angle ranging from 175 degrees to 185 degrees relative to the imaginary line.

In the above aspects, the cooling gas is blown to the portion that is farthest from the slit and has the lowest temperature, thereby effectively cooling the outer periphery and, consequently, further improving the evenness of the resistivity distribution.

In the monocrystalline silicon production apparatus of the above aspect, it is preferable that the cooling gas blower is located such that the cooling gas is blown between an outer edge of a solid-liquid interface of the monocrystalline silicon and a position 5-mm above the outer edge.

In the monocrystalline silicon production method of the above aspect, it is preferable that the cooling gas is blown between an outer edge of a solid-liquid interface of the monocrystalline silicon and a position 5-mm above the outer edge.

The outer periphery of the melt zone is unlikely to be cooled by blowing the cooling gas below the outer edge of the solid-liquid interface, since the outer periphery of the melt zone is hardly directly blown with the cooling gas. Similarly, the outer periphery is unlikely to be cooled by blowing the cooling gas to a position more than 5-mm away above from the outer edge of the solid-liquid interface, since the outer periphery cannot be blown with an appropriate volume of the cooling gas.

In contrast, in the above aspects, the cooling gas is blown to a portion in the above range to effectively cool the outer periphery and, consequently, improve the evenness of the resistivity distribution.

It is preferable that the monocrystalline silicon production apparatus of the above aspect further includes a level adjuster configured to adjust a level of a blowing position of the cooling gas blower.

When a single induction heating coil is used for producing a plurality of monocrystalline silicons, the induction heating coil tends to deteriorate and exhibit a poor heating capability. With the poor heating capability, the melt zone becomes thinner with a rise in the solid-liquid interface. Consequently, the cooling gas is blown below the solid-liquid interface, so that the outer periphery is unlikely to be cooled.

In contrast, in the above aspects, the level of the blowing position of the cooling gas blower can be adjusted depending on the deterioration of the induction heating coil so that the cooling gas can be directly blown to the outer periphery, thus improving the evenness of the resistivity distribution.

In the monocrystalline silicon production method of the above aspect, it is preferable that the cooling gas is blown from an end of a cooling gas nozzle at a flow rate ranging from 500 cc/min to 1000 cc/min, the end of the cooling gas nozzle being spaced from the outer periphery at an interval ranging from 5 mm to 15 mm.

In the above aspects, when the cooling gas is blown from the end of the cooling gas nozzle, which is spaced from the outer periphery at an interval ranging from 5 mm to 15 mm, at a flow rate of less than 500 cc/min, the outer periphery is unlikely to be sufficiently cooled due to an insufficient volume of the cooling gas. Meanwhile, when the cooling gas is blown from the above position at a flow rate exceeding 1000 cc/min, the outer periphery is rapidly cooled into a solid at a position blown with the cooling gas, sometimes causing the deformation of the monocrystalline silicon.

In contrast, in the above aspects, the cooling gas is blown from the above positon at a flow rate ranging from 500 cc/min to 1000 cc/min to sufficiently cool the outer periphery, allowing for improving the evenness of the resistivity distribution and preventing the deformation of the monocrystalline silicon.

**BRIEF DESCRIPTION OF DRAWING(S)**

Fig. 1 schematically shows a monocrystalline silicon production apparatus according to an exemplary embodiment of the invention.

Fig. 2 illustrates a position of a cooling gas nozzle relative to an induction heating coil.

Fig. 3 schematically shows the state of the occurrence of a flow in a melt zone.

Fig. 4 is a graph showing a relationship between the position of the cooling gas nozzle and resistivity distribution of a monocrystalline silicon in Experiment 1 related to Example(s) of the invention.

Fig. 5A is a graph showing a relationship between whether a cooling gas is blown and the resistivity distribution of the monocrystalline silicon in Experiment 2 related to Example(s) mentioned above, in particular, showing a result of blowing the cooling gas.

Fig. 5B is a graph showing a relationship between whether the cooling gas is blown and the resistivity distribution of the monocrystalline silicon in Experiment 2 related to Example(s) mentioned above, in particular, showing a result of blowing no cooling gas.

Fig. 6 illustrates the problem to be solved by the invention.

**DESCRIPTION OF EMBODIMENT(S)**

Exemplary Embodiment(s)

An Exemplary embodiment of the invention will be described below with reference to the attached drawings.

Configuration of Monocrystalline Silicon Production Apparatus

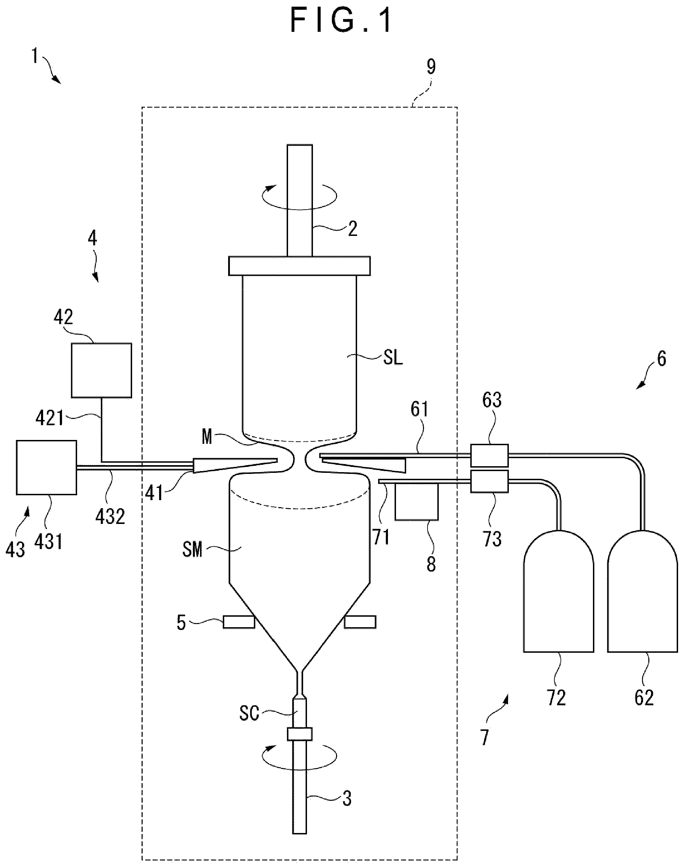

As shown in Fig. 1, a monocrystalline silicon production apparatus 1, which is configured to produce a monocrystalline silicon SM by the floating zone process (FZ method), includes an upper shaft 2, a lower shaft 3, a heater 4, a monocrystal holder 5, a doping gas blower 6, a cooling gas blower 7, a level adjuster 8, and a chamber 9.

The upper shaft 2 is configured to support a silicon material SL such that the silicon material SL is rotatable and vertically movable.

The lower shaft 3 is configured to support a seed crystal SC such that the seed crystal SC is rotatable and vertically movable.

The heater 4 includes an induction heating coil 41, a high-frequency power supply 42, and a coil cooler 43.

The induction heating coil 41 is configured to heat the silicon material SL to form a melt zone M and solidify the melt zone M to grow the monocrystalline silicon SM.

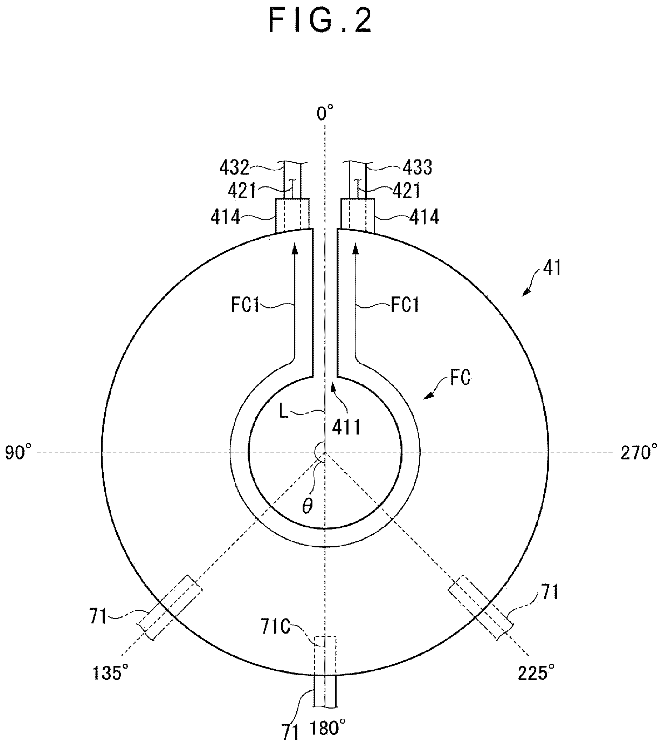

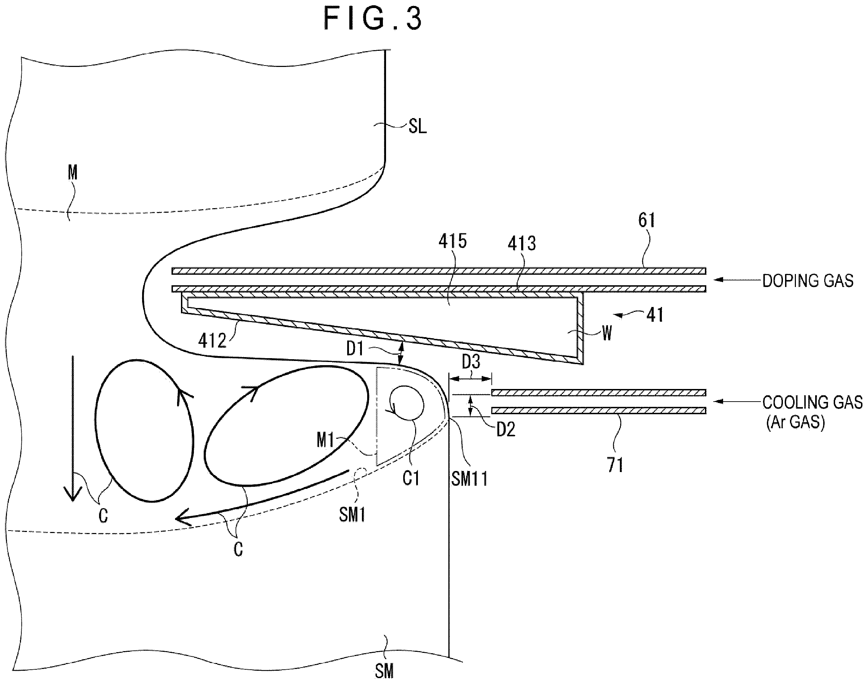

As shown in Fig. 2, the induction heating coil 41, which is made of a material consisting mainly of copper or silver, is substantially in a C-shape with a slit 411 in a top view. Additionally, as shown in Fig. 3, a bottom surface 412 of the induction heating coil 41 is slanted with an outer edge thereof located lower than an inner edge thereof. A top surface 413 of the induction heating coil 41 has flush outer and inner peripheries. It should be noted that the top surface 413 may be slanted with the outer edge thereof located higher than the inner edge thereof or, alternatively, may be parallel with the bottom surface 412. A pair of power terminals 414 are provided on an outer circumferential surface of the induction heating coil 41 at positions corresponding to respective ends of the C-shape (near the slit 411).

The high-frequency power supply 42 is configured to apply a high-frequency current FC to the induction heating coil 41 through a conductor 421 connected to each of the power terminals 414.

The coil cooler 43 includes a coolant supplying unit 431 that is configured to supply a coolant W to a hollow portion 415 of the induction heating coil 41 through a coolant supply pipe 432 to cool the induction heating coil 41, while discharging the coolant W used for cooling through a coolant discharge pipe 433.

The monocrystal holder 5 is configured to support the monocrystalline silicon SM as the monocrystalline silicon SM is grown large.

The doping gas blower 6 includes a doping gas nozzle 61 located on the top surface 413 of the induction heating coil 41, a doping gas cylinder 62 connected to an end of the doping gas nozzle 61, and a doping gas flow rate controller 63 configured to control a flow rate of a doping gas supplied from the doping gas cylinder 62. The doping gas blower 6 is configured to blow the doping gas to the melt zone M through the doping gas nozzle 61.

Examples of the doping gas include $PH_3$ and $B_2H_6$.

The cooling gas blower 7 is configured to blow a cooling gas to an outer periphery of the melt zone M below a position receiving the doping gas. Examples of the cooling gas include Ar gas, He gas, and Ar-gas-based $PH_3$ gas.

The cooling gas blower 7 includes a cooling gas nozzle 71 located below the bottom surface 412 of the induction heating coil 41, a cooling gas cylinder 72 connected to an end of the cooling gas nozzle 71, and a cooling gas flow rate controller 73 configured to control a flow rate of the cooling gas supplied from the cooling gas cylinder 72.

As shown in Fig. 2, the cooling gas nozzle 71 is preferably located such that the cooling gas can be blown to the outer periphery M1 of the melt zone M, the outer periphery M1 being, assuming that an imaginary line L connecting a center of the induction heating coil 41 and an outer end of the slit 411 is set as a reference (zero degrees), located at a position at an angle (hereinafter referred to as "cooling position angle") $\theta$ between the imaginary line L and a center axis 71C of cooling gas nozzle 71 in a top view, the angle $\theta$ ranging from 135 degrees to 225 degrees, more preferably ranging from 175 degrees to 185 degrees, further preferably being 180 degrees. In the exemplary embodiment, the cooling gas nozzle 71 is located as shown in solid lines in Fig. 2 so that the cooling gas is blown to the outer periphery M1 corresponding to the position at the cooling position angle $\theta$ of 180 degrees.

As shown in Fig. 3, the cooling gas nozzle 71 is located such that the cooling gas is blown to a portion between an outer edge SM11 of a solid-liquid interface SM1 of the monocrystalline silicon SM and a position 5-mm above the outer edge SM11 (i.e., a vertical blown range D2 shown in Fig. 3 ranging from 0 mm to 5 mm).

The cooling gas nozzle 71 is located such that the cooling gas can be blown from an end of the cooling gas nozzle 71 at a flow rate ranging from 500 cc/min to 1000 cc/min, the end of the cooling gas nozzle 71 being spaced from the outer periphery of the melt zone M at a nozzle interval D3 ranging from 5 mm to 15 mm.

At the nozzle interval D3 smaller than 5 mm, the cooling gas blown to a surface of the melt zone M causes vibrations in the melt zone M. In this case, the melt would be spilled or rapidly cooled into a solid, causing the deformation of the monocrystalline silicon SM. At the nozzle interval D3 exceeding 15 mm, the melt zone M is less effectively cooled, lowering an effect in improving the evenness of the resistivity distribution of the monocrystalline silicon SM.

An inner diameter of the cooling gas nozzle 71 preferably ranges from 1 mm to 3 mm. When the cooling gas nozzle 71 is not to be brought into contact with the induction heating coil 41 in use, the cooling gas nozzle 71 is preferably made of stainless steel. When the cooling gas nozzle 71 is possibly brought into contact, at least a portion of the cooling gas nozzle 71 that is possibly brought into contact with the induction heating coil 41 is preferably made of quartz.

The level adjuster 8 is configured to adjust a level of a blowing position of the cooling gas nozzle 71. For instance, the level adjuster 8 is vertically movable with the cooling gas nozzle 71 attached on a top thereof. In this case, the cooling gas nozzle 71 preferably has a first portion supported by the level adjuster 8 and a second portion defined between the first portion and the cooling gas flow rate controller 73, the second portion being flexible.

The chamber 9 is configured to accommodate at least the upper shaft 2, the lower shaft 3, the induction heating coil 41, the monocrystal holder 5, a part of each of the doping gas nozzle 61 and the cooling gas nozzle 71, and the level adjuster 8.

Monocrystalline Silicon Production Method

Next, a production method of the monocrystalline silicon SM with use of the production apparatus 1 will be described.

First, as shown in Fig. 1, the silicon material SL is fixed to the upper shaft 2 in the chamber 9, whereas the seed crystal SC (monocrystal) is fixed to the lower shaft 3. The silicon material SL may be a high-purity silicon polycrystal, which is prepared by purifying a silicon material such as monosilane, or a silicon monocrystal.

Further, a level of the cooling gas nozzle 71 is adjusted using the level adjuster 8 such that the vertical blown range D2 falls within a range from 0 mm to 5 mm. The level is preferably adjusted with reference to a position of the outer edge SM11 for the last production batch. Additionally, the level may be checked using an image captured with a camera and/or visually checked.

Subsequently, a lower portion of the silicon material SL is turned into the melt zone M by, while supplying Ar gas into the chamber 9, applying the high-frequency current FC to the induction heating coil 41 to melt the silicon material SL using the induction heating coil 41 and circulating the coolant through the hollow portion 415 of the induction heating coil 41.

The melt zone M is then brought into contact with the seed crystal SC to form a reduced-diameter neck with dislocation being eliminated therefrom. Subsequently, the monocrystalline silicon SM is grown on the seed crystal SC.

Specifically, the doping gas is blown from the doping gas blower 6 to the melt zone M with the position of the induction heating coil 41 being fixed while the upper shaft 2 and the lower shaft 3 are rotated in the same direction or opposite directions and, simultaneously, the silicon material SL and the monocrystalline silicon SM are moved downward so that the melt zone M is moved from a lower end to an upper end of the silicon material SL.

During the growth of the monocrystalline silicon SM, the cooling gas blower 7 blows the cooling gas to the outer periphery M1, which is below a position receiving the doping gas in the melt zone M, to cool the outer periphery M1.

By cooling the outer periphery M1, a temperature gradient in a vertical direction in the outer periphery M1 becomes smaller than a temperature gradient shown in Fig. 6, thus causing a flow C1, which is weaker than the flow C10, in the outer periphery M1 as shown in Fig. 3 (in Fig. 3, the flow C1 is shown by a line thinner than the flow C10 in Fig. 6 to indicate that the flow C1 is weaker than the flow C10). As a result, a diffusion boundary layer for the doping gas is thickened, increasing a volume of the doping gas incorporated into the outer periphery M1. As the volume of the incorporated doping gas increases, a resistivity of the outer periphery M1 is lowered, improving the evenness of the resistivity distribution of the monocrystalline silicon SM.

Further, as shown in Fig. 2, the cooling gas is blown to the outer periphery M1 from the cooling gas blower 7 at a position at the cooling position angle $\theta$ of 180 degrees.

Portions of the induction heating coil 41 opposite across the slit 411 have, unlike the other portions, a high current density due to opposing currents FC1, so that magnetic flux densities of these portions become largest as compared with the other portions. Thus, a portion of the outer periphery M1 under the slit 411 (i.e., under the imaginary line L) has the highest temperature. In contrast, a portion of the outer periphery M1 under a portion of the induction heating coil 41 opposite the slit 411 with respect to the center of the induction heating coil 41 (i.e., under the position at the cooling position angle $\theta$ of 180 degrees) has the lowest temperature.

In the exemplary embodiment, the cooling gas is blown to the portion of the outer periphery M1 with the lowest temperature to effectively cool the outer periphery M1, thus further improving the evenness of the resistivity distribution.

Further, the cooling gas blower 7 blows the cooling gas to a portion between the outer edge SM11 of the solid-liquid interface SM1 and a position 3-mm above the outer edge SM11. Thus, an appropriate volume of the cooling gas can be directly blown to the outer periphery M1 of the melt zone M to effectively cool the outer periphery M1, further improving the evenness of the resistivity distribution.

Additionally, the cooling gas blower 7 preferably blows the cooling gas to the outer periphery M1 at a flow rate ranging from 500 cc/min to 1000 cc/min.

By regulating the flow rate within the above range, the outer periphery M1 can be prevented from being insufficiently cooled due to an insufficient volume of the cooling gas as in the case of the flow rate being less than 500 cc/min. Additionally, the monocrystalline silicon SM can be prevented from being rapidly cooled into a solid, causing the deformation of the monocrystalline silicon SM as in the case of the flow rate being more than 1000 cc/min.

Modification(s)

It should be noted that the scope of the invention is not limited to the above exemplary embodiment but may include, subject to the appended claims, a variety of improvements and design changes as long as an object of the invention can be achieved.

For instance, the induction heating coil 41 may be moved upward to move the melt zone M toward a top of the silicon material SL.

**Example(s)**

Next, the invention will be described in more detail below with reference to Examples and Comparative Examples. However, it should be noted that the scope of the invention is by no means limited by these Examples.

Experiment 1: Relationship between the position of the cooling gas nozzle and the resistivity distribution of the monocrystalline silicon

Experimental Example 1

First, in the monocrystalline silicon production apparatus 1 shown in Fig. 1, the cooling gas nozzle 71 with an inner diameter of 1 mm was arranged such that the cooling position angle $\theta$ was 115 degrees, the vertical blown range D2 was 3 mm, and the nozzle interval D3 was 10 mm. The monocrystalline silicon SM with a diameter of 150 mm was then grown by blowing the doping gas to the melt zone M while blowing the cooling gas to a position below a position receiving the doping gas in the outer periphery M1 at a flow rate of 800 cc/min. The doping gas was $PH_3$. A target resistivity of the monocrystalline silicon SM was 50 $\Omega \cdot$ cm.

Ten wafers were sliced from the single monocrystalline silicon SM produced under the above conditions. A variation in in-plane resistivity of each wafer was evaluated.

An evaluation index for variation was RRG (Radial Resistivity Gradient). RRG represents a value in percentage that is obtained by dividing a difference between maximum and minimum of values of resistivity measured at a plurality of positions on a straight line passing through the center of the wafer by the minimum. In other words, when pmax denotes the maximum resistivity and pmin denotes the minimum resistivity, the RRG is represented by the following expression (1).

$$RRG = (\rho max - \rho min) / \rho min \times 100(\%)…(1)$$

An average of the respective RRG values of all the wafers were calculated as the RRG of the Experimental Example 1.

Experimental Examples 2 to 6

The monocrystalline silicon SM was produced in the same manner as in Experimental Example 1 except that the cooling position angle θ was set at 154.5 degrees for Experimental Example 2, 180 degrees for Experimental Example 3, 205.5 degrees for Experimental Example 4, 245 degrees for Experimental Example 5, and 270 degrees for Experimental Example 6. The RRG of each of Experimental Examples 2 to 6 was calculated based on RRG evaluation results of the same number of wafers as in Experimental Example 1.

Evaluation

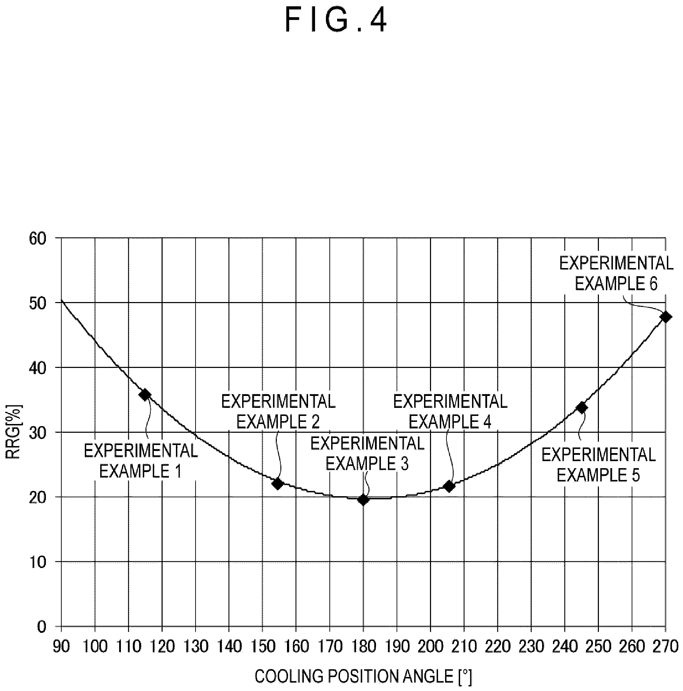

Fig. 4 shows a relationship between the cooling position angle and the RRG in each of Experimental Examples 1 to 6.

As shown in Fig. 4, it has been found that Experimental Example 3 with the cooling position angle θ of 180 degrees has the smallest RRG. The reason for the smallest RRG of Experimental Example 3 is speculated as follow.

The portion of the outer periphery M1 under the portion of the induction heating coil 41 opposite the slit 411 with respect to the center of the induction heating coil 41 has the lowest temperature as compared with the other portions. The cooling gas is blown to the portion with the lowest temperature to effectively cool the outer periphery M1, thus most reducing the flow C1 as compared with Experimental Examples 1, 2, and 4 to 6. It is thus speculated that the diffusion boundary layer for the doping gas is thickened to increase the volume of the doping gas incorporated into the outer periphery M1, improving the evenness of the resistivity distribution (i.e., reducing the RRG).

It has also been found that the RRG increases as the position of the cooling gas nozzle 71 is shifted closer to the slit 411 from the position at the cooling position angle θ of 180 degrees along a circumferential direction of the induction heating coil 41. The reason for the above is speculated as follow.

As the position of the cooling gas nozzle 71 is shifted from the position in Experimental Example 3 toward a position under the slit 411 along the circumferential direction of the induction heating coil 41, the temperature of the outer periphery M1 increases. Consequently, the flow C1 is gradually increased due to ineffectively cooling of the outer periphery M1. It is thus speculated that the volume of the doping gas incorporated into the outer periphery M1 reduces as the position of the cooling gas nozzle 71 is shifted toward the position under the slit 411, lowering the evenness of the resistivity distribution (i.e., increasing the RRG).

Additionally, it is speculated from the above speculated reason for a change in resistivity distribution that the RRG gradually increases with a gradual change in the position of the cooling gas nozzle 71 from a position at the cooling position angle θ of 90 degrees toward a position at 0 degrees or from a position at 270 degrees toward a position at 360 degrees (0 degrees).

It is also speculated that even when the cooling gas nozzle 71 is at a position at the cooling position angle θ of zero degrees, the RRG is still lowered to improve the evenness of the resistivity distribution by cooling the outer periphery M1 with the cooling gas as compared with an instance where no cooling gas is blown, although the melt zone M is less effectively cooled by blowing the cooling gas due to a high current density of the induction heating coil 41 (i.e., the high temperature of the melt zone M).

Experiment 2: Relationship between whether the cooling gas is blown and the resistivity distribution of the monocrystalline silicon

Experimental Example 7

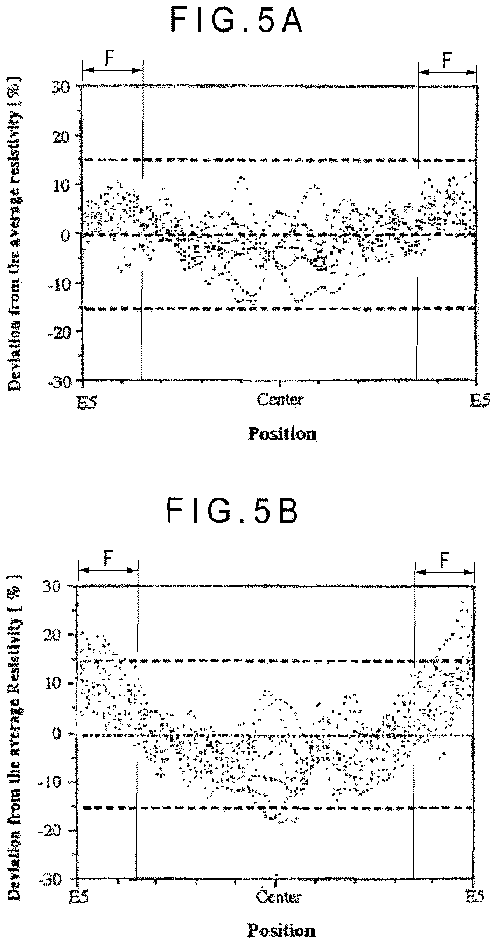

The single monocrystalline silicon SM was produced under the same conditions as in Experimental Example 3 of Experiment 1 and ten wafers were sliced from this monocrystalline silicon SM. A resistivity of each wafer was measured at a plurality of positions on a straight line passing through a center of the wafer and an in-plane resistivity variation was evaluated. Fig. 5A shows the results.

It should be noted that an ordinate axis ("Deviation from the average resistivity") in Fig. 5A indicates, with respect to an average of the values of resistivity at all the measurement points in the wafer, a deviation of the value of each measurement point from the average (i.e., zero). The deviation is calculated by the following expression (2).

$$\text{each measurement point / average of all measurement points} \times 100(\%) \dots (2)$$

An abscissa axis ("Position") in Fig. 5A indicates measurement positions for resistivity, which includes "Center" meaning the center of the wafer and "E5" meaning a position 5-mm inside an outer edge of the wafer.

Experimental Example 8

The single monocrystalline silicon SM was produced under the same conditions as in Experimental Example 7 except that no cooling gas was blown to the outer periphery M1 of the melt zone M. A resistivity of each of ten wafers sliced from the monocrystalline silicon SM was measured in the same manner as in Experimental Example 7 and an in-plane resistivity variation was evaluated. Fig. 5B shows the results.

Evaluation

By comparing the respective values of resistivity at the wafer peripheries (represented by a reference character F) in Figs. 5A and 5B, it has been found that the outer periphery M1 of Experimental Example 7, which was blown from the position at the cooling position angle θ of 180 degrees, exhibited substantially the same resistivity as the center of the wafer, whereas the outer periphery M1 of Experimental Example 8, which was not blown with the cooling gas, exhibited a resistivity higher than the center of the wafer by approximately 10% .

Thus, it has been found that the monocrystalline silicon SM produced by blowing the cooling gas to the outer periphery M1 of the melt zone M exhibits a reduced resistivity at the outer periphery thereof and an improved evenness of resistivity distribution as compared with a monocrystalline silicon produced without blowing a cooling gas.

**Claims**

1. A monocrystalline silicon production apparatus (1) configured to implement a floating zone process, the monocrystalline silicon production apparatus (1) comprising:

   an induction heating coil (41) configured to heat a silicon material (SL) to form a melt zone (M) and solidify the melt zone (M) to grow a monocrystalline silicon (SM), the induction heating coil (41) having a substantial ring shape, a bottom surface (412) of the induction heating coil (41) having an outer edge located lower than an inner edge;
   a doping gas blower (6) configured to blow a doping gas to the melt zone (M); and
   a cooling gas blower (7) configured to blow a cooling gas to an outer periphery (M1) of the melt zone (M) located below a position receiving the doping gas.

2. The monocrystalline silicon production apparatus (1) according to claim 1, wherein
   the induction heating coil (41) is provided with a slit (411) extending from an inner edge to an outer edge of the substantial ring shape, and
   the cooling gas blower (7) is located such that the cooling gas is blown to the outer periphery (M1) of the melt zone (M), the outer periphery (M1) being, assuming that an imaginary line (L) connecting a center of the induction heating coil (41) and an outer end of the slit (411) is set as a reference, located at a position at an angle (θ) ranging from 135 degrees to 225 degrees relative to the imaginary line (L) in a top view.

3. The monocrystalline silicon production apparatus (1) according to claim 2, wherein
   the cooling gas blower (7) is located such that the cooling gas is blown to the portion of the outer periphery (M1) of the melt zone (M), the portion of the outer periphery (M1) being located at the position at the angle (θ) ranging from 175 degrees to 185 degrees relative to the imaginary line (L).

4. The monocrystalline silicon production apparatus (1) according to any one of claims 1 to 3, wherein
   the cooling gas blower (7) is located such that the cooling gas is blown between an outer edge (SM11) of a solid-liquid interface (SM1) of the monocrystalline silicon (SM) and a position 5-mm above the outer edge (SM11).

5. The monocrystalline silicon production apparatus (1) according to any one of claims 1 to 4, further comprising
   a level adjuster (8) configured to adjust a level of a blowing position of the cooling gas blower (7).

6. A monocrystalline silicon production method based on a floating zone process, the method configured to be implemented using an induction heating coil (41) configured to heat a silicon material (SL) to form a melt zone (M) and solidify the melt zone (M) to grow a monocrystalline silicon (SM), the induction heating coil (41) having a substantial ring shape, a bottom surface (412) of the induction heating coil (41) having an outer edge located lower than an inner edge, the method comprising
   blowing a doping gas to the melt zone (M) while blowing a cooling gas to an outer periphery (M1) of the melt zone (M) located below a position receiving the doping gas to cool the outer periphery (M1) to grow the monocrystalline silicon (SM).

7. The monocrystalline silicon production method according to claim 6, wherein
   the induction heating coil (41) is provided with a slit (411) extending from an inner edge to an outer edge of the substantial ring shape, and
   the cooling gas is blown to a portion of the outer periphery (M1) of the melt zone (M), the portion of the outer periphery (M1) being, assuming that an imaginary line (L) connecting a center of the induction heating coil (41) and an outer end of the slit (411) is set as a reference, located at a position at an angle (θ) ranging from 135 degrees to 225 degrees relative to the imaginary line (L) in a top view.

8. The monocrystalline silicon production method according to claim 7, wherein
   the cooling gas is blown to the portion of the outer periphery (M1) of the melt zone (M), the portion of the outer periphery (M1) being located at the position at the angle (θ) ranging from 175 degrees to 185 degrees relative to the imaginary line (L).

9. The monocrystalline silicon production method according to any one of claims 6 to 8, wherein
   the cooling gas is blown between an outer edge (SM11) of a solid-liquid interface (SM1) of the monocrystalline silicon (SM) and a position 5-mm above the outer edge (SM11).

10. The monocrystalline silicon production method according to any one of claims 6 to 9, wherein
    the cooling gas is blown from an end of a cooling gas nozzle (71) at a flow rate ranging from 500 cc/min to 1000 cc/min, the end of the cooling gas nozzle (71) being spaced from the outer periphery (M1) at an interval ranging from 5 mm to 15 mm.

**Patentansprüche**

1. Vorrichtung zur Herstellung von monokristallinem Silicium (1), die zur Implementierung eines Schwebezonenprozesses ausgestaltet ist, wobei die Vorrichtung zur Herstellung von monokristallinem Silicium (1) umfasst:

   eine Induktionsheizspule (41), die zur Erwärmung von Siliciummaterial (SL), so dass eine Schmelzzone (M) gebildet wird, und zur Erstarrung der Schmelzzone (M), so dass monokristallines Silicium (SM) gezüchtet wird, ausgestaltet ist, wobei die Induktionsheizspule (41) eine wesentliche Ringform aufweist, wobei eine Bodenfläche (412) der Induktionsheizspule (41) eine Außenkante aufweist, die sich niedriger als eine Innenkante befindet; ein Dotierungsgasgebläse (6), das zum Blasen von Dotierungsgas zur Schmelzzone (M) ausgestaltet ist; und ein Kühlgasgebläse (7), das zum Blasen von Kühlgas zu einem Außenumfang (M1) der Schmelzzone (M), der sich unterhalb einer Position befindet, die das Dotierungsgas aufnimmt, ausgestaltet ist.

2. Vorrichtung zur Herstellung von monokristallinem Silicium (1) gemäß Anspruch 1, wobei
die Induktionsheizspule (41) mit einem Schlitz (411) versehen ist, der sich von einer Innenkante zu einer Außenkante der wesentlichen Ringform erstreckt, und
das Kühlgasgebläse (7) so angeordnet ist, dass das Kühlgas zum Außenumfang (M1) der Schmelzzone (M) geblasen wird, wobei, unter der Annahme, dass eine imaginäre Linie (L), die ein Zentrum der Induktionsheizspule (41) und ein äußeres Ende des Schlitzes (411) verbindet, als Referenz verwendet wird, sich der Außenumfang (M1) in einer Draufsicht an einer Position bei einem Winkel (θ) von 135 Grad bis 225 Grad relativ zur imaginären Linie (L) befindet.

3. Vorrichtung zur Herstellung von monokristallinem Silicium (1) gemäß Anspruch 2, wobei
das Kühlgasgebläse (7) so angeordnet ist, dass das Kühlgas zu dem Abschnitt des Außenumfangs (M1) der Schmelzzone (M) geblasen wird, wobei sich der Abschnitt des Außenumfangs (M1) an der Position bei einem Winkel (θ) von 175 Grad bis 185 Grad relativ zur imaginären Linie (L) befindet.

4. Vorrichtung zur Herstellung von monokristallinem Silicium (1) gemäß mindestens einem der Ansprüche 1 bis 3, wobei
das Kühlgasgebläse (7) so angeordnet ist, dass das Kühlgas zwischen eine Außenkante (SM11) einer Fest-Flüssig-Grenzfläche (SM1) des monokristallinen Siliciums (SM) und eine Position 5 mm über der Außenkante (SM11) geblasen wird.

5. Vorrichtung zur Herstellung von monokristallinem Silicium (1) gemäß mindestens einem der Ansprüche 1 bis 4, ferner umfassend
einen Höhenregler (8), der zur Einstellung der Höhe der Blasposition des Kühlgasgebläses (7) ausgestaltet ist.

6. Verfahren zur Herstellung von monokristallinem Silicium, das auf einem Schwebezonenprozess basiert, wobei das Verfahren so ausgestaltet ist, dass es unter Verwendung einer Induktionsheizspule (41) implementiert wird, die zur Erwärmung von Siliciummaterial (SL), so dass eine Schmelzzone (M) gebildet wird, und zur Erstarrung der Schmelzzone (M), so dass monokristallines Silicium (SM) gezüchtet wird, ausgestaltet ist, wobei die Induktionsheizspule (41) eine wesentliche Ringform aufweist, wobei eine Bodenfläche (412) der Induktionsheizspule (41) eine Außenkante aufweist, die sich niedriger als eine Innenkante befindet, das Verfahren umfassend
das Blasen von Dotierungsgas zur Schmelzzone (M), während ein Kühlgas zu einem Außenumfang (M1) der Schmelzzone (M), der sich unterhalb einer Position befindet, die das Dotierungsgas aufnimmt, zur Kühlung des Außenumfangs (M1) geblasen wird, so dass das monokristalline Silicium (SM) gezüchtet wird.

7. Verfahren zur Herstellung von monokristallinem Silicium gemäß Anspruch 6, wobei
die Induktionsheizspule (41) mit einem Schlitz (411) versehen ist, der sich von einer Innenkante zu einer Außenkante der wesentlichen Ringform erstreckt, und
das Kühlgas zu einem Abschnitt des Außenumfangs (M1) der Schmelzzone (M) geblasen wird, wobei, unter der Annahme, dass eine imaginäre Linie (L), die ein Zentrum der Induktionsheizspule (41) und ein äußeres Ende des Schlitzes (411) verbindet, als Referenz verwendet wird, sich der Abschnitt des Außenumfangs (M1) in einer Draufsicht an einer Position bei einem Winkel (θ) von 135 Grad bis 225 Grad relativ zur imaginären Linie (L) befindet.

8. Verfahren zur Herstellung von monokristallinem Silicium gemäß Anspruch 7, wobei
das Kühlgas zu dem Abschnitt des Außenumfangs (M1) der Schmelzzone (M) geblasen wird, wobei sich der Abschnitt des Außenumfangs (M1) an der Position bei einem Winkel (θ) von 175 Grad bis 185 Grad relativ zur imaginären Linie (L) befindet.

9. Verfahren zur Herstellung von monokristallinem Silicium gemäß mindestens einem der Ansprüche 6 bis 8, wobei
das Kühlgas zwischen eine Außenkante (SM11) einer Fest-Flüssig-Grenzfläche (SM1) des monokristallinen Siliciums (SM) und eine Position 5 mm über der Außenkante (SM11) geblasen wird.

10. Verfahren zur Herstellung von monokristallinem Silicium gemäß mindestens einem der Ansprüche 6 bis 9, wobei
das Kühlgas aus einem Ende einer Kühlgasdüse (71) mit einer Strömungsgeschwindigkeit von 500 cm$^3$/min bis 1000 cm$^3$/min geblasen wird, wobei das Ende der Kühlgasdüse (71) vom Außenumfang (M1) in einem Intervall von 5 mm bis 15 mm beabstandet ist.

**EP 3 483 310 B1**

**Revendications**

1. Appareil de production de silicium monocristallin (1) configuré pour mettre en œuvre une méthode de la zone flottante, l'appareil de production de silicium monocristallin (1) comprenant :

   une bobine de chauffage par induction (41) configurée pour chauffer un matériau de silicium (SL) pour former une zone fondue (M) et pour solidifier la zone fondue (M) pour faire croître un silicium monocristallin (SM), la bobine de chauffage par induction (41) présentant une forme sensiblement annulaire, une surface inférieure (412) de la bobine de chauffage par induction (41) présentant un bord externe situé plus bas qu'un bord interne ;
   une soufflante de gaz de dopage (6) configurée pour souffler un gaz de dopage vers la zone fondue (M) ; et
   une soufflante de gaz de refroidissement (7) configurée pour souffler un gaz de refroidissement vers une périphérie externe (M1) de la zone fondue (M) située en dessous d'une position recevant le gaz de dopage.

2. Appareil de production de silicium monocristallin (1) selon la revendication 1, dans lequel
   la bobine de chauffage par induction (41) est pourvue d'une fente (411) s'étendant depuis un bord interne vers un bord externe de la forme sensiblement annulaire, et
   la soufflante de gaz de refroidissement (7) est située de sorte que le gaz de refroidissement soit soufflé vers la périphérie externe (M1) de la zone fondue (M), la périphérie externe (M1) étant, en supposant qu'une ligne imaginaire (L) reliant le centre de la bobine de chauffage par induction (41) et une extrémité externe de la fente (411) soit définie comme référence, située à une position selon un angle (θ) dans la plage entre 135 degrés et 225 degrés par rapport à la ligne imaginaire (L) dans une vue du dessus.

3. Appareil de production de silicium monocristallin (1) selon la revendication 2, dans lequel
   la soufflante de gaz de refroidissement (7) est située de sorte que le gaz de refroidissement soit soufflé vers la périphérie externe (M1) de la zone fondue (M), la partie de la périphérie externe (M1) étant située à la position selon l'angle (θ) dans la plage entre 175 degrés et 185 degrés par rapport à la ligne imaginaire (L).

4. Appareil de production de silicium monocristallin (1) selon l'une quelconque des revendications 1 à 3, dans lequel la soufflante de gaz de refroidissement (7) est située de sorte que le gaz de refroidissement soit soufflé entre un bord externe (SM11) d'une interface solide-liquide (SM1) du silicium monocristallin (SM) et une position 5 mm au-dessus du bord externe (SM11).

5. Appareil de production de silicium monocristallin (1) selon l'une quelconque des revendications 1 à 4, comprenant en outre
   un dispositif d'ajustement de niveau (8) configuré pour ajuster un niveau d'une position de soufflage de la soufflante de gaz de refroidissement (7).

6. Procédé de production de silicium monocristallin basé sur une méthode de la zone flottante, le procédé étant configuré pour être mis en œuvre à l'aide d'une bobine de chauffage par induction (41) configurée pour chauffer un matériau de silicium (SL) pour former une zone fondue (M) et pour solidifier la zone fondue (M) pour faire croître un silicium monocristallin (SM), la bobine de chauffage par induction (41) présentant une forme sensiblement annulaire, une surface inférieure (412) de la bobine de chauffage par induction (41) présentant un bord externe situé plus bas qu'un bord interne, le procédé comprenant l'étape consistant à
   souffler un gaz de dopage vers la zone fondue (M) tout en soufflant un gaz de refroidissement vers une périphérie externe (M1) de la zone fondue (M) située en dessous d'une position recevant le gaz de dopage pour refroidir la périphérie externe (M1) pour faire croître le silicium monocristallin (SM).

7. Procédé de production de silicium monocristallin selon la revendication 6, dans lequel
   la bobine de chauffage par induction (41) est pourvue d'une fente (411) s'étendant depuis un bord interne vers un bord externe de la forme sensiblement annulaire, et
   le gaz de refroidissement est soufflé vers la périphérie externe (M1) de la zone fondue (M), la partie de la périphérie externe (M1) étant, en supposant qu'une ligne imaginaire (L) reliant le centre de la bobine de chauffage par induction (41) et une extrémité externe de la fente (411) soit définie comme référence, située à une position selon un angle (θ) dans la plage entre 135 degrés et 225 degrés par rapport à la ligne imaginaire (L) dans une vue de dessus.

8. Procédé de production de silicium monocristallin selon la revendication 7, dans lequel
   le gaz de refroidissement est soufflé vers la partie de la périphérie externe (M1) de la zone fondue (M), la partie de la périphérie externe (M1) étant située à la position selon l'angle (θ) dans la plage entre 175 degrés et 185 degrés par rapport à la ligne imaginaire (L).

9. Procédé de production de silicium monocristallin selon l'une quelconque des revendications 6 à 8, dans lequel le gaz de refroidissement est soufflé entre un bord externe (SM11) d'une interface solide-liquide (SM1) du silicium monocristallin (SM) et une position 5 mm au-dessus du bord externe (SM11).

10. Procédé de production de silicium monocristallin selon l'une quelconque des revendications 6 à 9, dans lequel le gaz de refroidissement est soufflé depuis une extrémité d'une buse de gaz de refroidissement (71) à un débit dans la plage entre 500 cc/min et 1000 cc/min, l'extrémité de la buse de gaz de refroidissement (71) étant espacée de la périphérie externe (M1) selon un intervalle dans la plage entre 5 mm et 15 mm.

# F I G . 1

# FIG.2

# FIG.3

DOPING GAS

COOLING GAS
(Ar GAS)

SL

61

41

W

413

415

412

D1

D3

D2

71

SM11

C1

M1

SM1

C

C

M

SM

# FIG.4

# FIG.5A

# FIG.5B

# F I G . 6

**EP 3 483 310 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017141130 A
- US 2003192470 A1
- JP 2013177254 A